**Europäisches Patentamt**

**European Patent Office**

**Office européen des brevets**

(19)

(11) Veröffentlichungsnummer : **0 084 323**
**B1**

(12) # EUROPÄISCHE PATENTSCHRIFT

(45) Veröffentlichungstag der Patentschrift :
30.07.86

(21) Anmeldenummer : 83100058.3

(22) Anmeldetag : 05.01.83

(51) Int. Cl.⁴ : **H 03 G   7/00**

(54) **Schaltungsanordnung zur Erzeugung einer von einer Wechselspannung abhängigen Steuerspannung.**

(30) Priorität : 15.01.82 DE 3201030
22.10.82 DE 3239138

(43) Veröffentlichungstag der Anmeldung :
27.07.83 Patentblatt 83/30

(45) Bekanntmachung des Hinweises auf die Patenterteilung : 30.07.86 Patentblatt 86/31

(84) Benannte Vertragsstaaten :
AT BE CH DE FR GB IT LI LU NL SE

(56) Entgegenhaltungen :
DE-B- 2 850 736
GB-A- 2 017 458
Die Akte enthält technische Angaben, die nach dem
Eingang der Anmeldung eingereicht wurden und die
nicht in dieser Patentschrift enthalten sind.

(73) Patentinhaber : TELEFUNKEN Fernseh und Rundfunk
GmbH
Göttinger Chaussee 76
D-3000 Hannover 91 (DE)

(72) Erfinder : Schröder, Ernst, Dipl.-Ing.
Pinkenburger Strasse 25D
D-3000 Hannover 51 (DE)

(74) Vertreter : Einsel, Robert, Dipl.-Ing.
TELEFUNKEN Fernseh und Rundfunk GmbH Göttinger Chaussee 76
D-3000 Hannover 91 (DE)

## Beschreibung

Die Erfindung bezieht sich auf eine Schaltungsanordnung zur Erzeugung einer von einer Wechselspannung abhängigen Steuerspannung, wie sie im Oberbegriff des Patentanspruchs 1 wiedergegeben ist.

Solche Schaltungsanordnungen sind in den eigenen Patenten DE-PS 28 30 784 und DE-PS 28 30 786 beschrieben. Es ist möglich, diese Schaltungsanordnungen als Steuerspannungserzeuger bei einem Kompander-System zu verwenden, wie es z. B. in der DE-PS 24 06 258 beschrieben ist. Bei der Kompander-Schaltung wird dem Eingang des Steuerspannungserzeugers bei Kompression das Wechselspannungs-Ausgangssignal und bei Expansion das Wechselspannungs-Eingangssignal eines elektronisch in seiner Verstärkung steuerbaren und im Nutzsignalweg liegenden Verstärkers zugeführt. Das Gleichspannungs-Ausgangssignal des Steuerspannungserzeugers wird dem Steuereingang des im Nutzsignalweg liegenden Verstärkers zugeführt. Der Steuerspannungserzeuger wirkt dabei so, daß er bei einer schnellen Erhöhung der dem Eingang des Steuerspannungserzeugers zugeführten Wechselspannung eine betragsmäßig sich schnell ändernde Gleichspannung erzeugt, die die Verstärkung des im Nutzsignalweg liegenden Verstärkers schnell verändert. Eine schnelle Änderung des Übertragungsmaßes des im Nutzsignalweg liegenden Verstärkers ist besonders dann wichtig, wenn sich der Pegel des Nutzsignals sprungartig in großen Bereichen ändert. Sonst besteht bei einem Pegelsprung von einem kleinen zu einem großen Wert die Gefahr des Überschwingens des Kompressorausgangssignals und damit der Übersteuerung des Übertragungskanals. Bei einem Pegelsprung in umgekehrter Richtung würden am Ausgang des Expanders in der Übergangszeit der Nachregelung Rauschsignale hörbar werden, die bei noch vorhandenem Nutzsignal verdeckt worden waren. Um ein komplementäres Verhalten von Kompressor und Expander zu erzielen, sollten zweckmäßig die für die Arbeitsweise des Kompressors und des Expanders spezifischen Merkmale bei Kompressor und Expander in gleicher Weise berücksichtigt werden.

Der Steuerspannungserzeuger zur Steuerung des Übertragungsmaßes der im Nutzsignalweg liegenden Verstärkers muß daher eine Steuerspannung liefern, die dem jeweiligen Pegel des Nutzsignals schnell angepaßt wird. Voraussetzung ist dafür eine bei großen Pegelsprüngen wirksame kurze Entladezeitkonstante am Ladekondensator des Steuerspannungserzeugers. Im stationären Zustand oder bei langsamen Pegeländerungen soll die Entladezeitkonstante jedoch groß sein, damit die Steuerspannung nicht im Takte der Nutzsignalfrequenz schwankt. Ein solches Verhalten hätte einen hohen Klirrfaktor zur Folge.

Es wird in diesem Zusammenhang der Ausdruck Entladung verwendet, wobei vorausgesetzt wird, daß die obigen Überlegungen sowohl für Schaltungen gültig sind, bei denen der Ladekondensator mit abnehmender Wechselspannungsamplitude entladen wird, als auch für solche, bei denen er geladen wird.

Bei der Bemessung der Entladezeitkonstanten des Ladekondensators müssen mehrere sich widersprechende Forderungen erfüllt werden, so daß eine Schaltungsanordnung zu schaffen war, die die Entladezeitkonstante unter Berücksichtigung einer großen Überschwingsicherheit, eines kleinen Klirrfaktors und des physiologischen Verdeckungseffektes von Rauschsignalen durch starke Nutzsignale steuerte.

Eine derartige Schaltungsanordnung ist in der deutschen Patentschrift P 28 50 736 beschrieben. Diese bekannte Lösung hat den Vorteil, daß die Verzögerungszeit des Verzögerungsgliedes im Hinblick auf eine kurze Dauer von unverdecktem Rauschen bei Einhaltung des zulässigen Klirrfaktors steuerbar ist.

In der eigenen Patentanmeldung P 28 12 431.4 ist eine Gleichrichterschaltung für eine Kompanderverfahren gemäß der deutschen Patentschrift P 28 50 736 beschrieben, die eine stückweise lineare Kennlinien durch eine Begrenzung der Gleichrichterspannung erzielt.

Der Erfindung liegt die Aufgabe zugrunde, eine nicht dem Grundprinzip der Patentschrift P 28 50 736 entsprechende Schaltungsanordnung zu schaffen, die gleichfalls die Umladezeitkonstanten unter Berücksichtigung einer großen Überschwingsicherheit, eines kleinen Klirrfaktors und des physiologischen Verdeckungseffektes von Rauschsignalen durch starke Nutzsignale steuert.

Weiterbildungen und vorteilhafte Ausführungsformen sind in den Unteransprüchen wiedergegeben.

Die Erfindung wird nun an Hand mehrerer Ausführungsbeispiele, die in der Zeichnung dargestellt sind, erläutert. Darin zeigen

Figur 1 eine einfache Ausführungsform der bekannten Schaltung,

Figur 2 ein Blockschaltbild einer zweiten bekannten Ausführungsform,

Figur 3 ein Schaltbild einer Ausführungsform gemäß der Erfindung,

Figur 4 eine Weiterbildung der Fig. 3,

Figur 5 eine Weiterbildung der Fig. 4,

Figur 6 eine weitere Ausführungsform der Fig. 5 und

Figur 7 eine Reihenschaltung mehrerer Dioden.

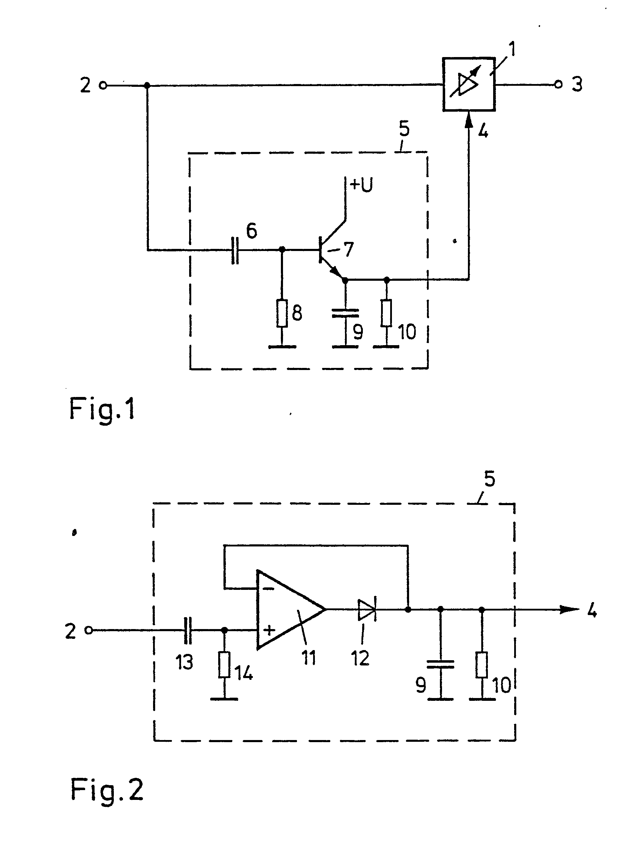

Fig. 1 zeigt das Blockschaltbild eines steuerbaren Verstärkers 1, dem an einer Eingangsklemme 2 eine Wechselspannung zugeführt wird. Eine verstärkte oder durch Steuerung veränderte, z. B. komprimierte oder expandierte Ausgangsspannung wird am Ausgang 3 abgegeben. Der Steuereingang 4 des Verstärkers 1 ist mit einer Steuerschaltung 5 verbunden, deren Eingang an die Eingangsklemme 2 angeschlossen ist. In der Steuerschaltung 5 gelangt die Wechselspannung über einen Kondensator 6 an die Basis eines Transistors 7, die zugleich über einen Widerstand 8 an Masse liegt. Im Emitterkreis des Transistors 7 liegt ein Ladekondensator 9, der über den Transistor 7 von einer Betriebsspannungsquelle + $U_B$ aufgeladen wird. Der Ladezustand des Ladekondensators 9 ist ein Maß für die Größe der dem Transistor 7 zugeführten Wechselspannung. Die Spannung des Ladekondensators wird direkt oder über einen weiteren Verstärker an den steuerbaren Verstärker weitergeleitet. Parallel zum Ladekondensator 9 ist ein Widerstand 10 geschaltet, der zugleich die Zeitkonstante der Schaltung mitdefiniert und einer permanenten Entladung des Kondensators 9 dient.

Eine solche Schaltung ist beschrieben in DE-AS 19 34 306.

Fig. 2 zeigt eine Steuerschaltung 5 nach Fig. 1 mit einem Operationsverstärker 11, dessen Ausgangsspannung einem Gleichrichter 12 zur Ladung des Ladekondensators 9 zugeführt wird. Die Wirkung der Schaltung entspricht im wesentlichen der an Hand Fig. 1 beschriebenen Schaltung.

Koppelkondensator 13 und Ableitwiderstand 14 entsprechen dem Bauelement 6,8 in Fig. 1, sind hier aber so dimensioniert, daß sie an den Eingangswiderstand des Operationsverstärkers 11 angepaßt sind.

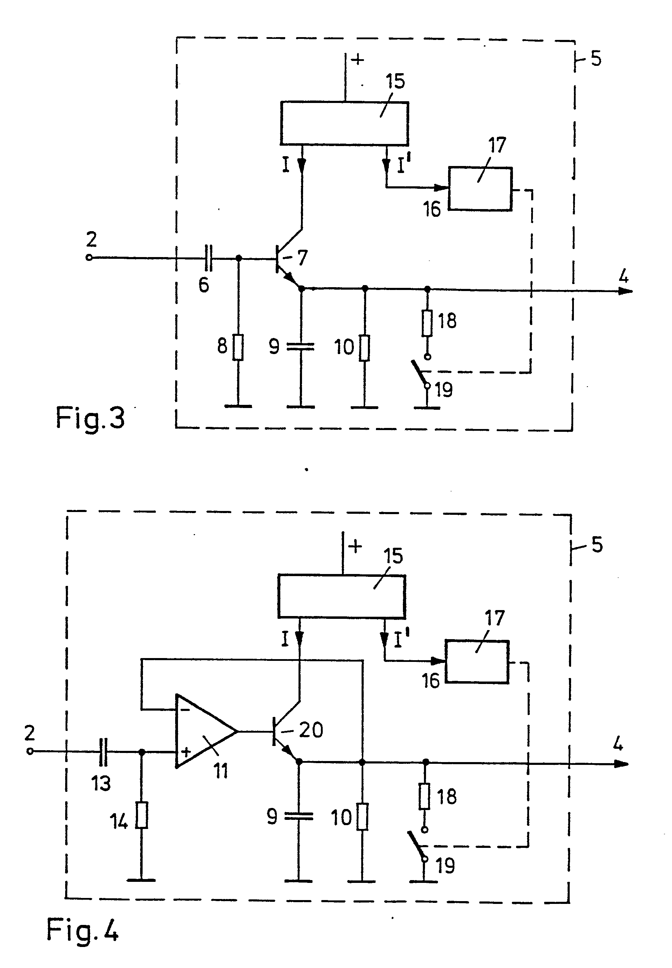

Der bei jeder Aufladung des Ladekondensators 9 fließende Strom J ist ein Maß für den Ladezustand des Kondensators 9. Dieser Strom fließt durch Transistor 7 oder Diode 12. Die Schaltungen nach Fig. 1 und 2 werden daher in den Schaltungen gemäß Fig. 3 und Fig. 4 so abgewandelt, daß die Größe der Spannung oder des Stromes am Kollektor des Transistors 7 in Fig. 1 oder am Kollektor eines als Diode 12 geschalteten Transistors 20 ausgewertet werden kann. In diesen abgewandelten Schaltungen ist in den jeweiligen Kollektorkreis der Transistoren 7,20 eine Stromspiegelschaltung 15 eingeschaltet, die einen zum Ladestrom gespiegelten Strom J' zum Stromsteuereingang 16 (strommempfindlicher Eingang) einer Kippschaltung 17 liefert. Als Kippschaltung kann z. B. ein sogenanntes Monoflop dienen, wie es in AEG-TELE-FUNKEN Wissenschaftliche Berichte 1/2 1979 auf Seite 103 beschrieben ist. Die Ausgangsgröße dieser Kippschaltung 17 dient zur Umschaltung eines Schalters 19, der in Serie mit einem Widerstand 18 parallel zum Widerstand 10 geschaltet ist. Der Schalter 19 kann Teil der Kippschaltung 17 sein.

Mit den soweit an Hand der Fig. 3 und 4 beschriebenen Schaltungen wird das Verhalten des Steuerspannungserzeugers bei einem Rückgang der Wechselspannungsamplitude verbessert.

Bei einem langsamen Abfall der Wechselspannungsamplitude erfolgt ein langsames Entladen des Ladekondensators durch den Widerstand 10. Die Zeitkonstante dieser langsamen Entladung ist so bemessen, daß bei der niedrigsten Signalfrequenz der maximal zulässige Klirrfaktor gerade erreicht wird. Die Zeitkonstante ist gegeben durch den Kondensator 9 und den Widerstand 10. Bei der Übertragung breitbandiger (z. B. elektroakustischer) Signale mit niedriger unterer Grenzfrequenz ist für die Einhaltung eines niedrigen Klirrfaktors eine große Zeitkonstante in der Größenordnung von einigen Sekunden erforderlich.

Bei einem schnellen Abfall der Wechselspannung erweist sich die große Entladezeitkonstante als störend, da z. B. beim Expander das Übertragungsmaß nicht schnell genug vermindert wird, so daß Störgeräusche der Übertragungsstrecke, die vorher vom starken Nutzsignal verdeckt waren, nun hörbar werden. In dem Fall einer schnellen Abnahme der Wechselspannungsamplitude ist daher eine kurze Entladezeit und damit eine kleine Entladezeitkonstante für den Steuerspannungserzeuger erforderlich. Um das zu erzielen, wird eine vom Ladestrom J für den ladekondensator 9 abhängige Größe wir die Spannung am Kollektor des Transistors 7 oder ein dem Strom J entsprechender Strom J' wie im Falle der Fig. 3 und 4 ausgewertet. Wenn das Nutzsignal kleiner wird, hört der Ladestrom J auf zu fließen. Dies läßt sich dazu auswerten, daß dann dem Widerstand 10 über den Schalter 19 ein Widerstand 18 parallel geschaltet wird. Dadurch wird die Entladung des Kondensators 9 z. B. um den Faktor 10 beschleunigt.

Mit Rücksicht auf eine unverzerrte Wiedergabe des letzten Schwingungszuges des starken Nutzsignals darf aber die Umschaltung auf die kleine Zeitkonstante erst dann erfolgen, wenn der letzte Schwingungszug beendet ist. Hierzu ist zwischen Stromspiegel 15 und Schalter 19 eine monostabile Kippstufe 17 eingefügt, die dazu führt, daß der Schalter 19 erst mit einer gewissen Verzögerung geschlossen wird, wenn der Strom J' zu Null wird. Da die längste Schwingungsdauer bei der niedrigsten Signalfrequenz auftritt, muß die Verzögerungszeit für die Umschaltung von der großen auf die kleine Zeitkonstante nach der niedrigsten Signalfrequenz bemessen werden. Wenn vor Ablauf dieser Verzögerungszeit die Nutzsignalamplitude auf einen kleinen Wert zurückgeht, ist am Ausgang des Expanders zwar unverdecktes Rauschen nachweisbar ; das menschliche Gehör benötigt aber eine gewisse Zeit, um sich von einem lauten Schalleindruck auf einen leisen umzustellen. Das unverdeckte Rauschen wird daher nicht wahrgenommen, wenn die Verzögerungszeit für die Umschaltung der Zeitkonstante kürzer gewählt wird, als die physiologische Anpaßzeit des menschlichen Gehörs beträgt.

Die eigene Patentanmeldung P 28 12 431.4 beschreibt eine Gleichrichterschaltung für ein Kompanderverfahren gemäß der deutschen Patentschrift P 28 50 736, die eine stückweise lineare Kennlinie durch Begrenzung der Gleichrichterspannung erzielt.

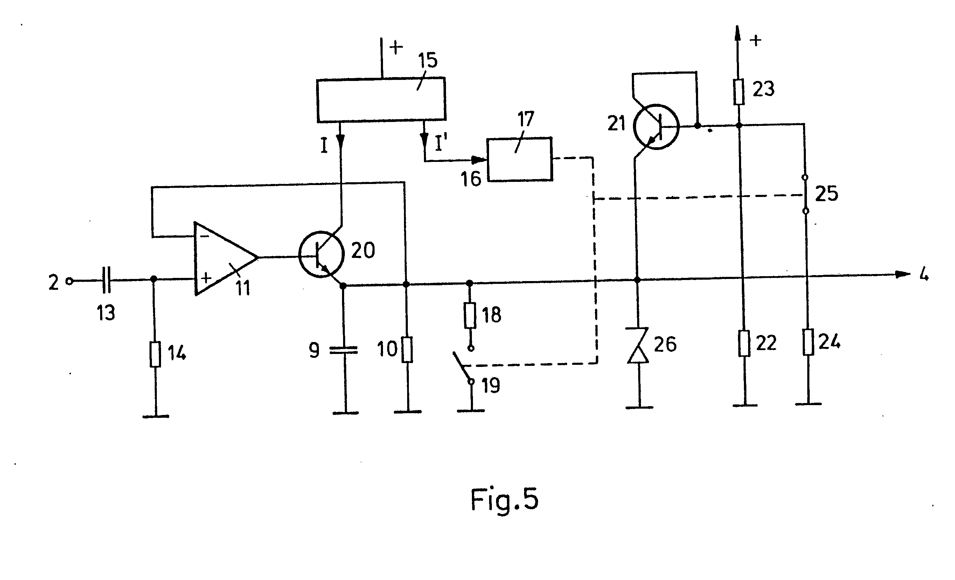

Zur Erzeugung einer stückweise linearen Kennlinie bei einer Schaltungsanordnung entsprechend Fig. 4 dienen in Fig. 5 die folgenden zusätzlichen Schaltungselemente. Ein mit der Versorgungsspannung verbundener Widerstand 23 ist mit einem als Diode geschalteten Transistor 21, einem Widerstand 22 und einer Serienschaltung, bestehend aus einem Schalter 25 und einem Widerstand 24, verbunden. Der Emitter des Transistors 21 führt auf die Ausgangsklemme 4. Die Schalter 19 und 25 sind wirkungsmäßig miteinander verbunden. Weiterhin ist die Ausgangsklemme 4 über eine Z-Diode 26 mit Masse verbunden.

In positiver Richtung wird die Steuerspannung am Punkt 4 durch die Z-Diode 26 begrenzt. Zur Festlegung des minimalen Wertes der Steuerspannung ist der Ausgang 4 über die Basis-Emitter-Strecke des Transistors 21 mit einer Referenzspannung verbunden. Diese Referenzspannung muß um die Basis-Emitter-Flußspannung des Transistors 21 höher sein als die am Ausgang 4 gewünschte minimale Spannung. Die Referenzspannung wird bei dieser Schaltung durch den Spannungsteiler, bestehend aus der Serienschaltung des Widerstandes 23 mit der Parallelschaltung aus Widerstand 22 und der Serienschaltung von Schalter 25 und Widerstand 24, aus der Betriebsspannung abgeleitet.

Liegt an der Eingangsklemme 2 kein Eingangssignal an, so ist der Schalter 19 geschlossen. Damit liegen die Widerstände 18, 10 parallel. Entsprechend der gewünschten minimalen Steuerspannung am Ausgang ergibt sich ein durch die Widerstände 18, 10 fließender Strom $I_1$. Dieser Strom $I_1$ fließt ebenfalls durch die Basis-Emitter-Strecke des Transistors 21 und ruft dort einen Spannungsabfall $U_1$ hervor :

$$U_1 = \frac{k \cdot T}{q} \cdot \ln (I_1/I_0) \approx 26 \text{ mV} \cdot \ln (I_1/I_0)$$

k ist die Boltzmann-Konstante, T die absolute Temperatur und q der Betrag der Elementarladung. $I_0$ ist eine Materialkonstante und bei üblichen Silizium-Transistoren etwa

$$I_0 \approx 10^{-14} \text{ A} .$$

Legt man nun an den Eingang 2 ein Eingangssignal an, das gerade geringfügig größer ist als das dem gewünschten unteren Kennlinienknick entsprechende Signal, so wird der Transistor 20 kurzzeitig während der Signalspitzen leitend. Der dann fließende Strom I durch den Transistor 20 wird in der Stromspiegelschaltung 15 gespiegelt. Der gespiegelte Strom I' triggert über den Stromeingang 16 die Kippschaltung 17, und der Schalter 19 wird geöffnet. Da jetzt der Widerstand 18 nicht mehr dem Widerstand 10 parallel geschaltet ist, reduziert sich der von Transistor 21 zu liefernde Strom zur Begrenzung der Steuerspannung an der Klemme 4 auf einen minimalen Wert von $I_1$ auf $I_1'$.

Damit reduziert sich auch die Basis-Emitter-Flußspannung des Transistors 21 von $U_1$ auf $U_1'$.

Ist der Wert des Widerstandes 10 allein z. B. 10x größer als die Parallelschaltung der Widerstände 10, 18, so gilt

$$I_1' \approx 0,1 \cdot I_1$$

Die Basis-Emitter-Flußspannung ändert sich um :

$$U_1 - U_1' = \frac{k \cdot T}{q} \ln (I_1/I_1')$$

und für das obige Beispiel um :

$$U_1 - U_1' \approx 26 \text{ mV} \cdot \ln 10 \approx 60 \text{ mV}$$

Damit steigt die durch den Transistor 22 und die Widerstände 22, 23 festgelegte minimale Steuerspannung um diese 60 mV. Dies ist unerwünscht und führt zu Verzerrungen im Bereich des unteren Knicks der gewünschten stückweise linearen Kennlinien eines Kompanders. Erfindungsgemäß läßt sich der so entstehende Anstieg der minimalen Steuerspannung am Ausgang 4 dadurch kompensieren, daß beim Öffnen des Schalters 19 die Referenzspannung um den Differenzbetrag der Flußspannungen des Transistors 21 abgesenkt wird. Dies wird z. B. dadurch erreicht, daß beim Öffnen des Schalters 19 gleichzeitig der Schalter 25 geschlossen wird, womit der Spannungsteiler zur Erzeugung der Referenzspannung durch Parallelschalten des Widerstandes 24 so verändert wird, daß sich die gewünschte Änderung der Referenzspannung ergibt.

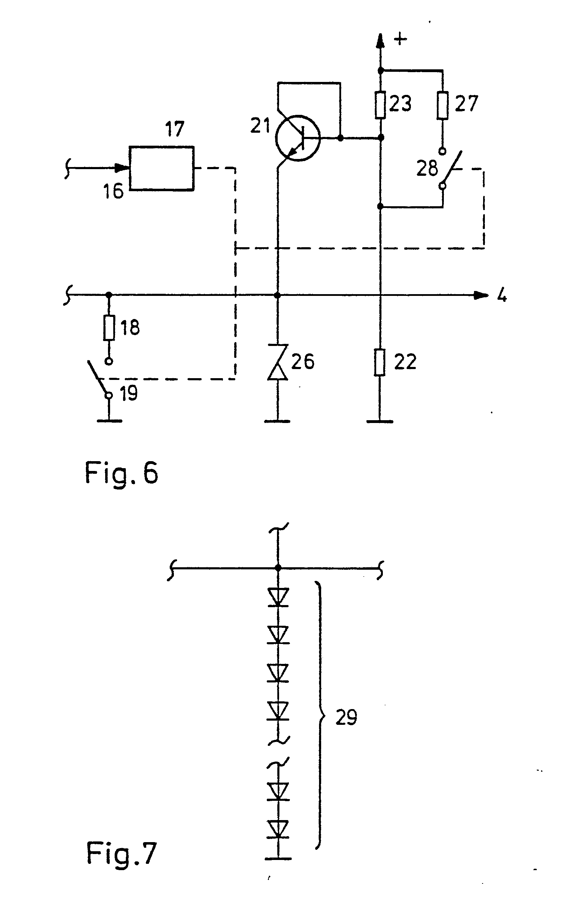

Fig. 6 zeigt ein Schaltbild mit einer weiteren Ausführungsform zur Anpassung der Referenzspannung an die unterschiedlichen Betriebsbedingungen. Dieses Schaltbild ist eine Ausschnittszeichnung von Fig. 5 und zeigt die Z-Diode 26, den Transistor 21, die Widerstände 22, 23, die in Serie geschaltet sind. Parallel zum Widerstand 23 liegt eine Serienschaltung aus einem Widerstand 27 und einem Schalter 28. Die Schalter 19 und 28 werden wie im vorhergehenden Ausführungsbeispiel synchron betätigt. Öffnet der Schalter 19, so wird auch der Schalter 28 geöffnet. Damit verändert sich der Spannungsteiler 23, 22 so, daß ebenfalls die gewünschte Änderung der Referenzspannung erzielt wird.

Es versteht sich, daß jede andere Schaltung anwendbar ist, die eine Referenzspannung an der basis des Transistors 21 synchron mit dem Schalten des Schalters 19 um den gewünschten Betrag verändert.

Fig. 7 zeigt eine Serienschaltung einer Anzahl von Dioden 29, die anstelle der Z-Diode 26 eine Begrenzung des maximalen Wertes der Steuerspannung bewirkt.

**Patentansprüche**

1. Schaltungsanordnung zur Erzeugung einer von einer Wechselspannung abhängigen Steuerspannung mit einem Ladekondensator (9), dessen Ladezustand über steuerbare Lade- und Entladestromkreise in Abhängigkeit der Wechselspannung in der Weise veränderbar ist, daß bei Zunahme der Wechselspannungsamplitude der Ladekondensator (9) über eine Ventilschaltung (7, 12, 20) aufgeladen wird und bei Abnahme der Wechselspannungsamplitude der Leitwert eines Entladestromkreises (10, 18) erhöht wird, wobei im Steuerweg für den Entladestromkreis ein Verzögerungsglied (17) angeordnet ist, wobei der Leitwert des Entladestromkreises in Abhängigkeit der Zeitdifferenz zwischen einer Zunahme und einer Abnahme der Wechselspannungsamplitude steuerbar ist und wobei zur Änderung des Ladezustandes die Wechselspannung ausgewertet wird, dadurch gekennzeichnet, daß zur Auswertung der Wechselspannung der Ladestrom dem Ladekondensator (9) über die Emitter-Kollektor-Strecke eines Transistors (7, 20) zugeführt wird, dessen Kollektorspannung ein Maß für den Ladezustand ist, und daß die Kollektorspannung oder der Kollektorstrom oder eine entsprechende Größe einer Auswerteschaltung zugeführt wird.

2. Schaltungsanordnung nach Anspruch 1, dadurch gekennzeichnet, daß in den Kollektorkreis eine Stromspiegelschaltung (15) eingeschaltet ist, und daß der gespiegelte Strom dem strommempfindlichen Steuereingang (16) einer Kippschaltung (17) zugeführt wird.

3. Schaltungsanordnung nach Anspruch 2, dadurch gekennzeichnet, daß die Kippschaltung (17) ein Monoflop ist.

4. Schaltungsanordnung nach Anspruch 1, dadurch gekennzeichnet, daß eine von der Wechselspannung abhängige Steuerspannung durch Begrenzungsmittel (21-28) begrenzt wird, und daß die Schaltungsmittel (24, 25, 27, 28) eine minimale Steuerspannung bei veränderten Betriebsbedingungen konstant halten.

5. Schaltungsanordnung nach Anspruch 4, dadurch gekennzeichnet, daß die minimale Steuerspannung aus einer Referenzspannung gewonnen wird.

6. Schaltungsanordnung nach Anspruch 3 oder 4, dadurch gekennzeichnet, daß die Referenzspannung durch Öffnen oder Schließen eines Schalters (25, 28) in ihrem Wert verändert wird.

7. Schaltungsanordnung nach einem oder mehreren der vorangehenden Ansprüche, dadurch gekennzeichnet, daß der Schalter (19) zur Änderung des Leitwertes des Entladestromkreises (10, 18, 19) und der Schalter (25, 28) zur Anpassung der Referenzspannung gleichzeitig betätigt werden.

8. Schaltungsanordnung nach Anspruch 4, dadurch gekennzeichnet, daß der maximale Wert der Steuerspannung durch eine Z-Diode (26) bestimmt wird.

9. Schaltungsanordnung nach Anspruch 4, dadurch gekennzeichnet, daß der maximale Wert der Steuerspannung durch eine Reihenschaltung aus mehreren Dioden (29) bestimmt wird.

**Claims**

1. Circuit arrangement for achieving a control voltage dependent on an alternating voltage, having a load condenser (9) the charging state of which is variable by way of controllable charging and discharging circuits in dependence upon the alternating voltage in such a way that upon occurrence of an increase of the alternating voltage amplitude the load condenser (9) is charged by way of a valve circuit (7, 12, 20) and on the occurrence of a decrease of the alternating voltage amplitude the conductance of a discharging circuit (10, 18) is increased, wherein in the control path for the discharging circuit a delay member (17) is arranged whereby the conductance of the discharging circuit is controllable in dependence upon the time difference between an increase and a decrease of the alternating voltage amplitude and wherein for the alteration of the charging state the alternating voltage is observed, characterized in that for the observation of the alternating voltage the charging current is conducted to the load condenser through the emitter-collector path of a transistor (7, 20), the collector voltage of which constitutes a measure of the charging state, and that the collector voltage or the collector current or a corresponding magnitude is applied to an observation circuit.

2. Circuit arrangement according to Claim 1, characterized in that a current mirror circuit (15) is connected in the collector circuit and that the mirrored current is applied to the current-sensitive control input (16) of a Kipp circuit (17).

3. Circuit arrangement according to Claim 2, characterized in that the Kipp circuit (17) is a monoflop.

4. Circuit arrangement according to Claim 1, characterized in that a control voltage dependent upon the alternating voltage is limited by limiting means (21-28) and that the switching means (24, 25, 27, 28) maintain a minimal control voltage constant in the event of altered operational conditions.

5. Switching arrangement according to Claim 4, characterized in that the minimal control voltage is derived from a reference voltage.

6. Circuit arrangement according to Claim 3 or 4, characterized in that the reference voltage is altered in value by the opening or closing of a switch (25, 28).

7. Circuit arrangement according to one or more of the foregoing claims, characterized in that the switch (19) for altering the conductance of the discharging circuit (10, 18, 19) and the switch (25, 28) for adjusting the reference voltage are simultaneously actuated.

8. Circuit arrangement according to Claim 4, characterized in that the maximum value of the control voltage is determined by a Z-diode (26).

9. Circuit arrangement according to Claim 4, characterized in that the maximum value of the control voltage is determined by a series of several diodes (29).

## Revendications

1. Circuit pour produire une tension de commande fonction d'une tension alternative, comportant un condensateur de charge (9), dont la condition de charge est modifiable par l'intermédiaire de circuits de charge et de décharge pouvant être commandés en fonction de la tension alternative d'une manière telle que, lors d'une augmentation de l'amplitude de tension alternative, le condensateur de charge (9) soit chargé par l'intermédiaire d'un circuit redresseur (7, 12, 20) alors que, lors d'une diminution de l'amplitude de la tension alternative, la conduction d'un circuit de courant de décharge (10, 18) est augmentée, un organe de retardement (17) étant disposé dans la voie de commande pour le circuit de courant de décharge, la conduction du circuit de courant de décharge pouvant être commandée en fonction de la différence temporelle entre une augmentation et une diminution de l'amplitude de tension alternative et la tension alternative étant évaluée pour la modification de la condition de charge, caractérisé en ce que, pour l'évaluation de la tension alternative, le courant de charge est appliqué au condensateur de charge (9) par l'intermédiaire de la voie émetteur-collecteur d'un transistor (7, 20), dont la tension de collecteur est une mesure de la condition de charge et en ce que la tension de collecteur ou le courant de collecteur ou grandeur correspondante est appliquée à un circuit d'évaluation.

2. Circuit selon la revendication 1, caractérisé en ce que dans le circuit de collecteur est branché un circuit de réflexion de courant (15) et en ce que le courant réfléchi est appliqué à l'entrée de commande (16), sensible à un courant, d'un circuit basculant (17).

3. Circuit selon la revendication 2, caractérisé en ce que le circuit basculant (17) est un mono-stable.

4. Circuit selon la revendication 1, caractérisé en ce qu'une tension de commande fonction de la tension alternative est limitée par des moyens de limitation (21-28) et en ce que les composants de circuit (24, 25, 27, 28) maintiennent constante une tension minimale de commande dans le cas de conditions variables de fonctionnement.

5. Circuit selon la revendication 4, caractérisé en ce que la tension minimale de commande est obtenue à partir d'une tension de référence.

6. Circuit selon la revendication 3 ou 4, caractérisé en ce que la valeur de la tension de référence est modifiée par ouverture ou fermeture d'un commutateur (25, 28).

7. Circuit selon une ou plusieurs des revendications précédentes, caractérisé en ce que le commutateur (19) est actionné pour modifier la valeur de conduction du circuit de courant de décharge (10, 18, 19) tandis que les commutateurs (25, 28) sont actionnés simultanément pour une adaptation de la tension de référence.

8. Circuit selon la revendication 4, caractérisé en ce que la valeur maximale de la tension de commande est déterminée par une diode Zener (26).

9. Circuit selon la revendication 4, caractérisé en ce que la valeur maximale de la tension de commande est déterminée par un circuit-série se composant de plusieurs diodes (29).

**Fig.1**

**Fig.2**

Fig.3

Fig.4

Fig.5

Fig. 6

Fig. 7

4